# EUROPEAN PATENT APPLICATION

(11) **EP 2 518 786 A1**
(43) Date of publication of application: **31.10.2012**
(21) Application number: 11163783.1
(22) Date of filing: 26.04.2011
(51) Int. Cl.: H01L 41/053, H01L 41/08

(54) **Electronic device**

(71) Applicant: Research In Motion Limited, Waterloo, ON N2L 3W8 (CA)
(72) Inventor: Paleczny, Todd Robert, Waterloo Ontario N2L 3W8 (CA)
(74) Representative: Fennell, Gareth Charles

(57) **Abstract**

An assembly (202) includes a frame (206), a substrate (204) coupled to the frame by a plurality of flexible members (208) such that the substrate is moveable relative to the frame (206), and a piezoelectric device (210) coupled to the substrate (204) and configured to move the substrate (204) relative to the frame (206).

## Description

### FIELD OF TECHNOLOGY

The present disclosure relates to electronic devices including, but not limited to, electronic devices having displays and their control.

### BACKGROUND

Electronic devices, including portable electronic devices, have gained widespread use and may provide a variety of functions including, for example, telephonic, electronic messaging and other personal information manager (PIM) application functions. Portable electronic devices include several types of devices including mobile stations such as simple cellular telephones, smart telephones (smart phones), Personal Digital Assistants (PDAs), tablet computers, and laptop computers, with wireless network communications or near-field communications connectivity such as Bluetooth® capabilities.

Portable electronic devices such as PDAs, or tablet computers are generally intended for handheld use and ease of portability. Smaller devices are generally desirable for portability. A touch-sensitive display, also known as a touchscreen display, is particularly useful on handheld devices, which are small and may have limited space for user input and output. The information displayed on the display may be modified depending on the functions and operations being performed. Improvements in electronic devices with displays are desirable.

### SUMMARY

An assembly includes a frame, a substrate coupled to the frame by a plurality of flexible members, such that the substrate is moveable relative to the frame, and a piezoelectric device coupled to the substrate and configured to move the substrate relative to the frame. An electronic device includes a housing, a touch-sensitive display disposed in the housing, a frame, a substrate coupled to the frame by a plurality of flexible members, such that the substrate is moveable relative to the frame, a piezoelectric device coupled to the substrate and configured to move the substrate relative to the frame to apply force to the touch-sensitive display. An assembly includes a frame, a plurality of substrates coupled to the frame by a plurality of flexible members, such that the substrates are moveable relative to the frame, and a plurality of piezoelectric devices coupled to the substrates and configured to move the substrates relative to the frame.

### BRIEF DESCRIPTION OF THE DRAWINGS

FIG. 1 is a block diagram of a portable electronic device in accordance with the disclosure.

FIG. 2 is a bottom view of an example of an actuator assembly in accordance with the disclosure.

FIG. 3 is a top view of an example of the actuator assembly in accordance with the disclosure.

FIG. 4 is a sectional side view of a portable electronic device with piezo actuators in accordance with the disclosure.

FIG. 5 is a block diagram including force sensors and actuators of the portable electronic device in accordance with the disclosure.

FIG. 6 is a bottom view of an example of an actuator in accordance with the disclosure.

FIG. 7 is a side view of an example of an actuator in accordance with the disclosure.

FIG. 8 is a top view of an example of an actuator assembly including the actuator in accordance with the disclosure.

### DETAILED DESCRIPTION

The following describes an electronic device and an assembly that includes a frame, a substrate coupled to the frame by a plurality of flexible members, such that the substrate is moveable relative to the frame, and a piezoelectric device coupled to the substrate and configured to move the substrate relative to the frame.

For simplicity and clarity of illustration, reference numerals may be repeated among the figures to indicate corresponding or analogous elements. Numerous details are set forth to provide an understanding of the embodiments described herein. The embodiments may be practiced without these details. In other instances, well-known methods, procedures, and components have not been described in detail to avoid obscuring the embodiments described. The description is not to be considered as limited to the scope of the embodiments described herein.

The disclosure generally relates to an electronic device, which is a portable or non-portable electronic device in the embodiments described herein. Examples of portable electronic devices include mobile, or handheld, wireless communication devices such as pagers, cellular phones, cellular smart-phones, wireless organizers, personal digital assistants, wirelessly enabled notebook computers, tablet computers, mobile internet devices, and so forth. Examples of non portable electronic devices include electronic white boards, smart boards utilized for collaboration, built-in displays in furniture or appliances, and so forth. The electronic device may be a portable electronic device without wireless communication capabilities, such as a handheld electronic game, digital photograph album, digital camera, or other device. The electronic device may also be a portable electronic device without wireless communication capabilities, such as handheld electronic games, digital photograph albums, digital cameras, media players, e-book readers, and so forth.

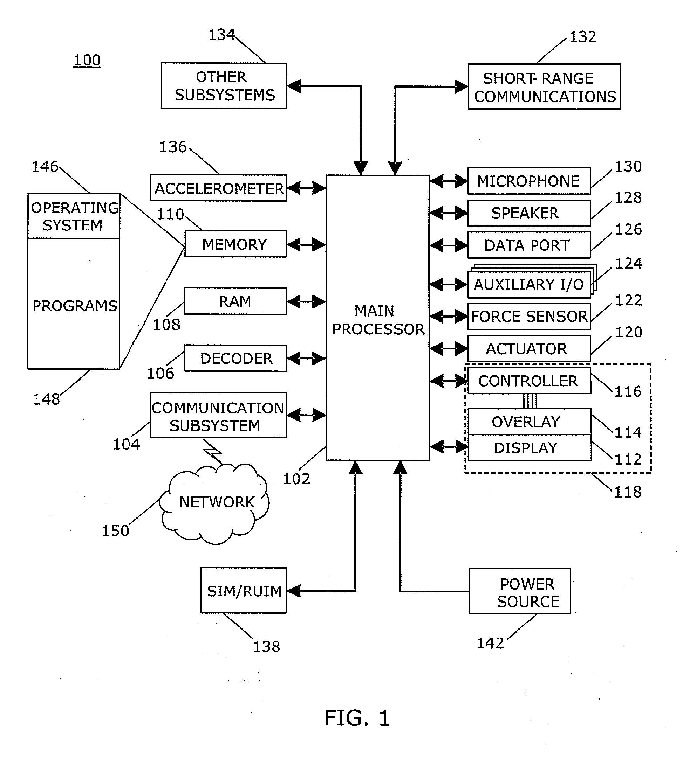

A block diagram of an example of an electronic device 100 is shown in FIG. 1. The electronic device 100, which may be a portable electronic device, includes multiple components, such as a processor 102 that controls the overall operation of the electronic device 100. The electronic device 100 presently described optionally includes a communication subsystem 104 and a short-range communications 132 module to perform various communication functions, including data and voice communications. Data received by the electronic device 100 is decompressed and decrypted by a decoder 106. The communication subsystem 104 receives messages from and sends messages to a wireless network 150. The wireless network 150 may be any type of wireless network, including, but not limited to, data wireless networks, voice wireless networks, and networks that support both voice and data communications. A power source 142, such as one or more rechargeable batteries or a port to an external power supply, powers the electronic device 100.

The processor 102 interacts with other components, such as Random Access Memory (RAM) 108, memory 110, a display 112 with a touch-sensitive overlay 114 operably connected to an electronic controller 116 that together comprise a touch-sensitive display 118, one or more actuators 120, an auxiliary input/output (I/O) subsystem 124, a data port 126, a speaker 128, a microphone 130, short-range communications 132, and other device subsystems 134. User-interaction with a graphical user interface is performed through the touch-sensitive overlay 114. The processor 102 interacts with the touch-sensitive overlay 114 via the electronic controller 116. Information, such as text, characters, symbols, images, icons, and other items that may be displayed or rendered on an electronic device, is displayed on the touch-sensitive display 118 via the processor 102. Optionally, the processor 102 may interact with one or more force sensors 122. The processor 102 may also interact with an orientation sensor such as an accelerometer 136 to detect direction of gravitational forces or gravity-induced reaction forces, for example, to determine the orientation of the electronic device 100.

To identify a subscriber for network access, the electronic device 100 may optionally use a Subscriber Identity Module or a Removable User Identity Module (SIM/RUIM) card 138 for communication with a network, such as the wireless network 150. Alternatively, user identification information may be programmed into memory 110.

The electronic device 100 includes an operating system 146 and software programs or components 148 that are executed by the processor 102 and are typically stored in a persistent, updatable store such as the memory 110. Additional applications or programs may be loaded onto the electronic device 100 through the wireless network 150, the auxiliary I/O subsystem 124, the data port 126, the short-range communications subsystem 132, or any other suitable subsystem 134.

A received signal, such as a text message, an e-mail message, or web page download, is processed by the communication subsystem 104 and input to the processor 102. The processor 102 processes the received signal for output to the display 112 and/or to the auxiliary I/O subsystem 124. A subscriber may generate data items, for example e-mail messages, which may be transmitted over the wireless network 150 through the communication subsystem 104, for example.

The touch-sensitive display 118 may be any suitable touch-sensitive display, such as a capacitive, resistive, infrared, surface acoustic wave (SAW) touch-sensitive display, strain gauge, optical imaging, dispersive signal technology, acoustic pulse recognition, and so forth, as known in the art. A capacitive touch-sensitive display may include a capacitive touch-sensitive overlay 114. The overlay 114 may be an assembly of multiple layers in a stack which may include, for example, a substrate, a ground shield layer, a barrier layer, one or more electrode layers separated by a substrate or other barrier, and a cover. The capacitive touch sensor layers may be any suitable material, such as patterned indium tin oxide (ITO).

One or more touches, also known as touch contacts or touch events, may be detected by the touch-sensitive display 118. The processor 102 may determine attributes of the touch, including a location of a touch. Touch location data may include an area of contact or a single point of contact, such as a point at or near a center of the area of contact. A signal is provided to the controller 116 in response to detection of a touch. A touch may be detected from any suitable object, such as a finger, thumb, appendage, or other items, for example, a stylus, pen, or other pointer, depending on the nature of the touch-sensitive display 118. The controller 116 and/or the processor 102 may detect a touch by any suitable contact member on the touch-sensitive display 118. Multiple simultaneous touches may be detected.

The actuator(s) 120 may be depressed by applying sufficient force to the touch-sensitive display 118 to overcome the actuation force of the actuator 120. The actuator 120 may be actuated by pressing anywhere on the touch-sensitive display 118. The actuator 120 may provide input to the processor 102 when actuated. Actuation of the actuator 120 may result in provision of tactile feedback. Other different types of actuators 120 may be utilized than those described herein. When force is applied, the touch-sensitive display 118 is depressible, pivotable, and/or movable.

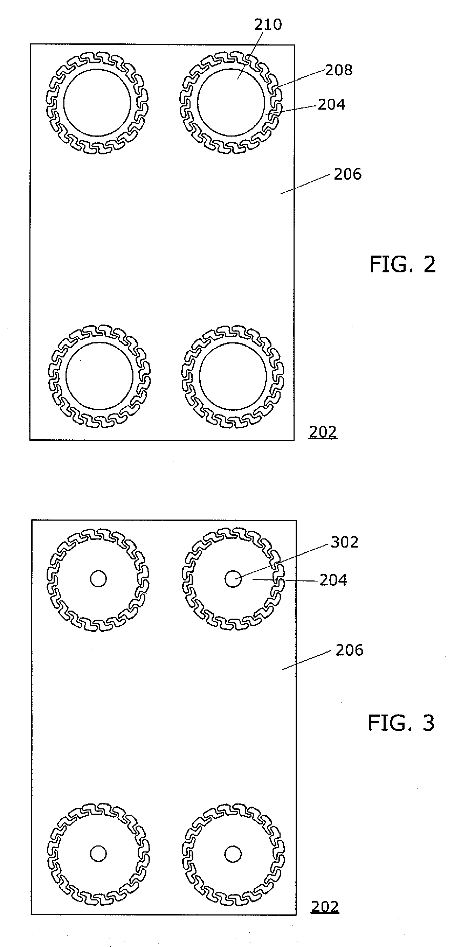

A bottom view of an actuator assembly is shown in FIG. 2 and a top view of the actuator assembly is shown in FIG. 3. The actuator assembly 202 includes a plurality of substrates 204, which may also be referred to as shims. In the example illustrated in FIG. 2 and FIG. 3, the actuator assembly 202 includes four substrates 204 that are generally disk-shaped. The substrates 204 are comprised of a metal, such as nickel, or any other suitable metal, such as a stainless steel, brass, and so forth.

The substrates 204 are coupled to a frame 206 by a plurality of flexible members 208 that are distributed around the substrates 204. The frame 206 and the flexible members 208 are metal and may be comprised of the same metal as the substrates 204. The frame 206, the flexible members 208, and the substrates 204 may be formed from a single sheet of metal, for example, by stamping, machining, or utilizing any suitable metalworking process or processes. The shape and the number of flexible members joining the substrates 204 to the frame 206 may differ from the shape and number illustrated in this example. Radial stresses, force, and displacement of the substrate may be modified by changing the number and shape of the flexible members.

The flexible members 208 may be thin extensions of metal distributed radially around the substrates 204 and joining the substrates 204 to the frame 206. The connection point of each of the flexible members 208 to the substrates 204 may be offset radially from the connection points of each of the flexible members 208 to the frame 206. The flexible members 208 may be non-linear, for example, Z or S-shaped, and are resilient, or elastically deformable, such that the flexible members 208 act as springs to facilitate movement of the substrates 204 relative to the frame 206. Any suitable shape of flexible members may be utilized, and one example of suitable flexible members is illustrated in FIG. 2 and FIG. 3.

Each actuator 120, also referred to herein as a piezo actuator 120, may comprise a piezoelectric ("piezo") device or element 210, such as piezoelectric ceramic disk, fastened to a substrate 204, for example, by adhesive, lamination, laser welding, and/or by other suitable fastening method or device. The piezoelectric material may be lead zirconate titanate or any other suitable material. Although the piezo element 210 is a ceramic disk in this example, the piezoelectric material may have any suitable shape and geometrical features, for example a non-constant thickness, chosen to meet desired specifications. The substrates 204 bend when the piezo elements 210 contract diametrically, as a result of build up of charge/increased voltage at the piezo element 210, causing movement of at least a portion of the substrate 204 away from the frame 206. The substrates 204 return to the position illustrated in FIG. 2 and FIG. 3 when the charge is reduced.

Pads 302 may be disposed on an opposite side of the substrates 204 as the piezo elements 210, as illustrated in FIG. 3. The pads 302 in the present example are a compressible element that may provide at least minimal shock-absorbing or buffering protection and may comprise suitable material, such as a hard rubber, silicone, and/or polyester, and/or other materials. The pads 302 are advantageously flexible and resilient and may provide a bumper or cushion for the piezo actuator 120 as well as facilitate actuation of the piezo actuator 120.

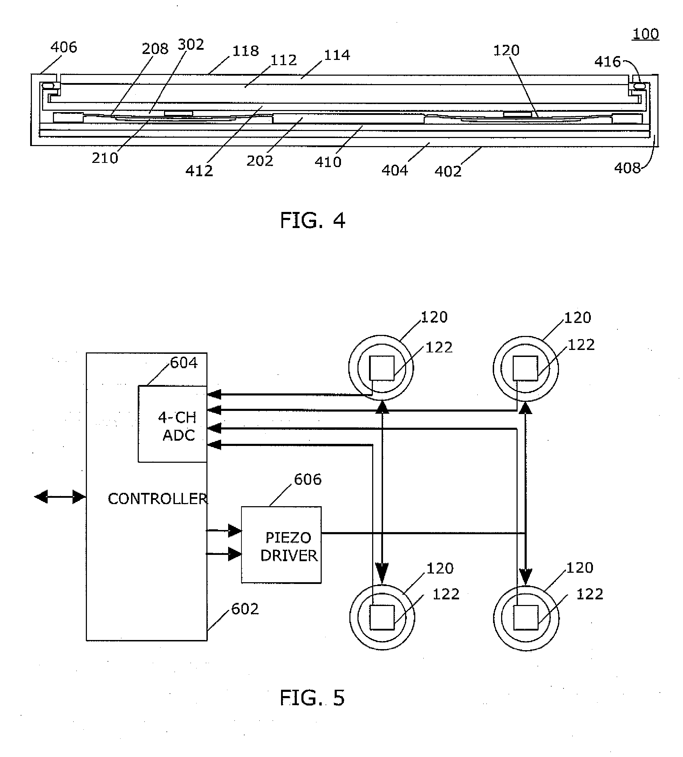

The actuator assembly 202 may be assembled and utilized in the portable electronic device 100. A cross section of a portable electronic device 100 taken through the centers of piezoelectric ("piezo") actuators 120 is shown in FIG. 4. The portable electronic device 100 includes a housing 402 that encloses components such as shown in FIG. 1. The housing 402 may include a back 404, sidewalls 408, and a front 406 that houses the touch-sensitive display 118. A base 410 extends between the sidewalls 408, generally parallel to the back 404, and supports the actuator assembly 202. The base 410 may be, for example, a printed circuit board. The actuator assembly 202 may be disposed in the portable electronic device 100 such that the piezo elements 210 are disposed between the substrate 208 and the base 410 and the pads 302 are disposed between the substrate 208 and a support tray 412 of the touch-sensitive display 118. The display 112 and the overlay 114 are supported on the support tray 412 of suitable material, such as magnesium. Optional spacers 416 may be located between the support tray 412 and the front 406, may advantageously be flexible, and may also be compliant or compressible, and may comprise gel pads, spring elements such as leaf springs, foam, and so forth.

The optional force sensors 122 may be disposed between the pad 302 and the support tray 412 or between the pad 302 and the substrate 208, to name a few examples. The force sensors 122 may be force-sensitive resistors, strain gauges, piezoelectric or piezoresistive devices, pressure sensors, or other suitable devices. Force as utilized throughout the specification, including the claims, refers to force measurements, estimates, and/or calculations, such as pressure, deformation, stress, strain, force density, force-area relationships, thrust, torque, and other effects that include force or related quantities. A piezoelectric device, which may be the piezo element 210, may be utilized as a force sensor.

When the touch-sensitive display 118 is depressed, the force sensors 122 generate a force signal that is received and interpreted by the microprocessor 102. The pads 302 are advantageously aligned with the force sensors 122 to facilitate the focus of forces exerted on the touch-sensitive display 118 onto the force sensors 122. The pads 302 transfer forces between the touch-sensitive display 118 and the actuators 120 whether the force sensors 122 are above or below the pads 302. The pads 302 facilitate provision of tactile feedback from the actuators 120 to the touch-sensitive display 118 without substantially dampening the force applied to or on the touch-sensitive display 118.

Force information related to a detected touch may be utilized to select information, such as information associated with a location of a touch. For example, a touch that does not meet a force threshold may highlight a selection option, whereas a touch that meets a force threshold may select or input that selection option. Selection options include, for example, displayed or virtual keys of a keyboard; selection boxes or windows, e.g., "cancel," "delete," or "unlock"; function buttons, such as play or stop on a music player; and so forth. Different magnitudes of force may be associated with different functions or input. For example, a lesser force may result in panning, and a higher force may result in zooming.

A block diagram including force sensors and actuators of the portable electronic device 100 is shown in FIG. 5. In this example, each force sensor 122 is electrically connected to a controller 502, which includes an amplifier and analog-to-digital converter (ADC) 504. Each force sensor 122 may be, for example, a force-sensing resistor wherein the resistance changes as force applied to the force sensor 122 changes. As applied force on the touch-sensitive display 118 increases, the resistance decreases. This change is determined via the controller 116 for each of the force sensors 122, and a value representative of the force at each of the force sensors 122 may be determined.

The piezo actuators 120 are electrically coupled to a piezo driver 504 that communicates with the controller 502 by an electrical connection to the metal frame 206, for example. The controller 502 is also in communication with the main processor 102 of the portable electronic device 100 and may exchange signals with the main processor 102. The piezo actuators 120 and the force sensors 122 are operatively coupled to the main processor 102 via the controller 502. The controller 502 controls the piezo driver 506 that controls the current/voltage to the metal frame 206 to which the actuators 120 are coupled, and thus the controller 502 controls the force applied by the piezo actuators 120 on the touch-sensitive display 118. The piezo actuators 120 may be controlled substantially equally and concurrently, for example, by the same signal that may be provided through a common control line that extends to the metal frame 206 or by control lines that extend to the substrates 204. The piezo elements 210 may be grounded while a negative voltage, for example, between -150V and 0 may be applied to the metal frame 206 to provide the voltage/charge at the piezo actuators 120.

The tactile feeling of switches, actuators, keys, other physical objects, and so forth may be simulated, or a non-simulated tactile feedback may be provided by controlling the piezoelectric devices 210. For example, when a force applied on the touch-sensitive display 118 exceeds a depression threshold, a signal is identified and the voltage/charge at the piezo actuators 120 is applied according to the signal such that the piezo actuators 120 impart a force on the touch-sensitive display 118, which force may, for example, simulate depression of a dome switch. When the force applied on the touch-sensitive display 118 falls below a release threshold, the voltage/charge at the piezo actuators 120 is modified such that the piezo actuator 120 imparts a force or discontinues imparting a force on the touch-sensitive display 118, which may, for example, simulate release of a dome switch.

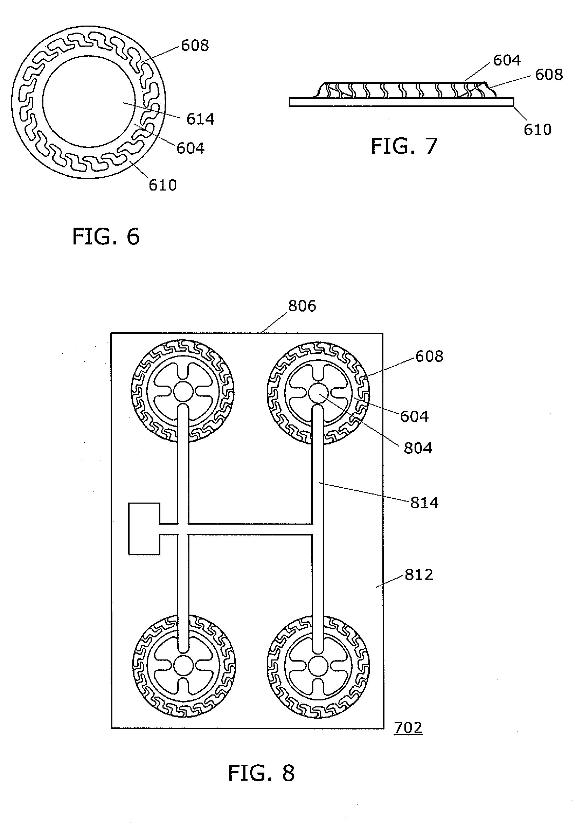

A bottom view of an actuator is shown in FIG. 6, and the actuator assembly, including the actuator of FIG. 6, is shown in FIG. 7. The actuator assembly includes a substrate 604 that may be generally disk-shaped. The substrate 604 is comprised of metal, such as nickel, or any other suitable metal. A metal band 610 may extend around the substrate 604 and is coupled to the substrate 604 by a plurality of flexible members 608 that are distributed around the substrate 604. The metal band 610, the flexible members 608, and the substrate 604 are comprised of the same metal and may be formed from a single sheet of metal, utilizing any suitable metalworking process.

The flexible members 608 may be thin extensions of metal distributed radially around the substrate 604 between the substrate and the metal band 610. The connection point of each of the flexible members 608 to the substrate 604 may be offset radially from the connection points of each of the flexible members 608 to the band 610. The flexible members 608 may be non-linear, for example, and are resilient, or elastically deformable, such that the flexible members 608 act as springs to facilitate movement of the substrate 604 relative to the band 610.

FIG. 7 is a side view of the actuator illustrated in FIG. 6. In the example illustrated in FIG. 7, the actuator may comprise a piezo element 614 and is actuated. When the actuator is actuated, the substrate 604 bends or buckles elastically as the piezo element 614 contracts. The edge of the substrate 604 is moved away from the metal band 610 and the flexible members 608 flex to facilitate movement of the substrate 604 relative to the metal band 610.

In the example illustrated in FIG. 8, the actuator assembly 802 includes four substrates 604. Any other suitable number of substrates 604 may be utilized. A plastic sheet 812 is overmolded around the metal bands 610 such that the metal bands 610 are coupled to the plastic sheet 812. The metal bands 610 and the plastic sheet 812 together comprise the frame 806. Optionally the flexible members 608 may vary in width or in thickness. For example, the flexible members 608 may be wider at the actuator assembly, wider at the ends than in the middle, or may be wider at one end and may gradually taper.

Each actuator may comprise a piezo element 614 fastened to a substrate 604, as described above with reference to FIG. 2 and FIG. 3. Pads 804 may also be disposed on an opposite side of the substrates 604 as the piezo element 614 and optional force sensors may be utilized between the substrates 604 and the pads, for example.

The piezo actuators may be electrically coupled to each other by, for example, an electrical connection to the piezo elements 614. The substrates 604 may be electrically coupled to each other by an electrical connection to the substrates 604, as illustrated by the electrical connectors 814 in FIG. 8. Alternatively, the piezo elements 614 may be electrically isolated from each other and may be controlled separately. A controller, such as the controller illustrated in FIG. 5, may control a piezo driver that controls current/voltage to the substrates 604. Alternatively, the controller may control the piezo driver to control current/voltage to the piezo elements 614. Utilizing the plastic sheet 812, the substrates 604 may be electrically isolated from each other. The piezo elements 614 may also be electrically isolated from each other and may be controlled separately.

Actuators such as piezo actuators may be assembled utilizing a frame to provide an actuator assembly. Pads and optional force sensors may also be included in the actuator assembly to reduce the number of separate components that are utilized in the construction of a portable electronic device that includes actuators to provide tactile feedback. A reduction in the number of separate components may facilitate control and reduction of mechanical tolerances for the components utilized in the portable electronic device, which may facilitate a reduction in thickness of the portable electronic device.

The present disclosure may be embodied in other specific forms without departing from its spirit or essential characteristics. The described embodiments are to be considered in all respects only as illustrative and not restrictive. The scope of the present disclosure is, therefore, indicated by the appended claims rather than by the foregoing description. All changes that come within the meaning and range of equivalency of the claims are to be embraced within their scope.

## Claims

1. An assembly comprising:
a frame;
a substrate coupled to the frame by a plurality of flexible members, such that the substrate is moveable relative to the frame;
a piezoelectric device coupled to the substrate and configured to move the substrate relative to the frame.

2. The assembly according to claim 1, wherein the flexible members are resilient to facilitate movement of the substrate from a first position to a second position away from the frame and return of the substrate to the first position.

3. The assembly according to claim 1, wherein the flexible members are elastically deformable to facilitate movement of the substrate from a first position to a second position away from the frame and return of the substrate to the first position.

4. The assembly according to claim 1, wherein the plurality of flexible members comprise thin extensions of metal extending from the substrate to the frame.

5. The assembly according to claim 1, wherein the frame comprises a metal band coupled to the substrate, and a plastic sheet molded to the metal band.

6. The assembly according to claim 1, comprising:
a further substrate coupled to the frame by a further plurality of flexible members such that the further substrate is moveable relative to the frame,
a further piezoelectric device disposed on the further substrate and configured to move the further substrate relative to the frame.

7. The assembly according to claim 6, wherein the substrates are metal and are electrically coupled.

8. The assembly according to claim 6, wherein the frame comprises metal bands coupled to the substrates and a plastic sheet molded around the metal band.

9. The assembly according to claim 1, wherein the substrate comprises a metal disk and the piezoelectric device comprises a piezoelectric disk actuator.

10. An electronic device comprising:
a housing;
a touch-sensitive display disposed in the housing;
a frame;
a substrate coupled to the frame by a plurality of flexible members, such that the substrate is moveable relative to the frame;
a piezoelectric device coupled to the substrate and configured to move the substrate relative to the frame to apply force to the touch-sensitive display.

11. The electronic device according to claim 10, wherein the flexible members are resilient to facilitate movement of the substrate from a first position to a second position away from the frame and return of the substrate to the first position.

12. The electronic device according to claim 10, wherein the flexible members are elastically deformable to facilitate movement of the substrate from a first position to a second position away from the frame and return of the substrate to the first position.

13. The electronic device according to claim 10, comprising a printed circuit board, the assembly disposed between the printed circuit board and the touch-sensitive display.

14. The electronic device according to claim 10, wherein the touch-sensitive input device is biased against the force applied by the piezoelectric device.

15. The electronic device according to claim 10, comprising:
a further substrate coupled to the frame by a further plurality of flexible members such that the further substrate is moveable relative to the frame,
a further piezoelectric device disposed on the further substrate and configured to move the further substrate relative to the frame to apply force to the touch-sensitive display.

## Amended claims

### Amended claims in accordance with Rule 137(2) EPC.

**1.** An assembly (202, 802) comprising:
a frame (206, 806);
a substrate (204, 604) coupled to the frame (206, 806) by a plurality of flexible members (208, 608), such that the substrate (204, 604) is moveable relative to the frame (206, 806);
a piezoelectric device (210, 614) coupled to the substrate (204, 604) and configured to move the substrate (204, 604) relative to the frame (206, 806).

**2.** The assembly (202, 802) according to claim 1, wherein the flexible members (208, 608) are resilient to facilitate movement of the substrate (204, 604) from a first position to a second position away from the frame (206, 806) and return of the substrate (204, 604) to the first position.

**3.** The assembly according to claim 1, wherein substrate (204, 604) is substantially disk-shaped and the flexible members are distributed radially around the substrate (204, 604).

**4.** The assembly (202, 802) according to claim 1, wherein the plurality of flexible members (208, 608) comprise thin extensions of metal extending from the substrate (204, 604) to the frame (206, 806).

**5.** The assembly (802) according to claim 1, wherein the frame (806) comprises a metal band (610) coupled to the substrate (604), and a plastic sheet (812) molded to the metal band (610).

**6.** The assembly (202, 802) according to claim 1, comprising:
a further substrate (204, 604) coupled to the frame (206, 806) by a further plurality of flexible members (208, 608) such that the further substrate (604) is moveable relative to the frame (206, 806),
a further piezoelectric device (210, 614) disposed on the further substrate (204, 604) and configured to move the further substrate (204, 604) relative to the frame (206, 806).

**7.** The assembly (802) according to claim 5, wherein the substrates (204, 604) are metal and are electrically coupled to each other.

**8.** The assembly (802) according to claim 5, wherein the frame (806) comprises metal bands (610) coupled to the substrates (204, 604) and a plastic sheet (812) molded around the metal bands (610).

**9.** The assembly (202, 802) according to claim 1, wherein the substrate (204, 604) comprises a metal disk and the piezoelectric device (210, 614) comprises a piezoelectric disk actuator.

**10.** An electronic device (100) comprising:
a housing (402);
a touch-sensitive display (118) disposed in the housing (402);
a frame (206, 806);
a substrate (204, 604) coupled to the frame (206, 806) by a plurality of flexible members (208, 608), such that the substrate (204, 604) is moveable relative to the frame (206, 806);
a piezoelectric device (210, 614) coupled to the substrate (204, 604) and configured to move the substrate (204, 604) relative to the frame (206, 806) to apply force to the touch-sensitive display (118).

**11.** The electronic device (100) according to claim 10, wherein the flexible members (208, 608) are resilient to facilitate movement of the substrate (204, 604) from a first position to a second position away from the frame (206, 806) and return of the substrate (204, 604) to the first position.

**12.** The electronic device (100) according to claim 10, wherein the flexible members (208, 608) are elastically deformable to facilitate movement of the substrate (204, 604) from a first position to a second position away from the frame (206, 806) and return of the substrate (204, 604) to the first position.

**13.** The electronic device according to claim 9, comprising a printed circuit board, the frame (206, 806), the substrate (204, 604), and the piezoelectric device (210, 610) are each disposed between the printed circuit board and the touch-sensitive display (118).

**14.** The electronic device (100) according to claim 10, wherein the touch-sensitive input device (118) is biased against the force applied by the piezoelectric device (210, 614).

**15.** The electronic device (100) according to claim 10, comprising:
a further substrate (204, 604) coupled to the frame by a further plurality of flexible members (208, 608) such that the further substrate (204, 604) is moveable relative to the frame (206, 806),
a further piezoelectric device (210, 614) disposed on the further substrate (204, 604) and configured to move the further substrate (204, 604) relative to the frame (206, 806) to apply force to the touch-sensitive display (118).
